# EUROPEAN PATENT SPECIFICATION

(11) **EP 2 549 841 B1**
(45) Date of publication and mention of the grant of the patent: **16.09.2015**
(21) Application number: 11174804.2
(22) Date of filing: 21.07.2011
(51) Int. Cl.: H05K 3/34, H05K 3/12, H05K 9/00

(54) **Grooved circuit board accommodating mixed-size components**
Gerillte Leiterplatte mit Bauteilen unterschiedlicher Größe
Carte de circuit rainurée avec des composants de taille mixte

(43) Date of publication of application: 23.01.2013
(73) Proprietor: BlackBerry Limited, Waterloo, ON N2K 0A7 (CA)
(72) Inventor: Li, Fan, Waterloo, Ontario N2L 3W8 (CA); Huang, Jie, Waterloo, Ontario N2L 3W8 (CA); Jassal, Surinder, Waterloo, Ontario N2L 3W8 (CA)
(74) Representative: MERH-IP Matias Erny Reichl Hoffmann

(56) References cited:
- EP-A1- 1 445 999
- US-A1- 2001 002 877
- US-B1- 6 462 436

## Description

### TECHNICAL FIELD

The present technology relates generally to circuit boards and circuit assemblies comprising same, and, in particular, to circuit boards for accommodating a variety of component sizes.

### BACKGROUND

Printed circuit boards allow for reliable and cost-effective production of electronic devices. A common technique for populating printed circuit boards with components, for example surface-mount components, involves applying solder paste to desired areas of a printed circuit board through a specially configured stencil. The components are then pressed into the solder paste, and the populated circuit board is passed through an oven to reflow the solder paste.

Some printed circuit assemblies call for a mixture of different sized components, such as small or fine-pitched component leads alongside components with large leads or a large footing to be attached to the circuit board. This situation arises, for example, when a radiofrequency (RF) shield is used to isolate other electronic components. The RF shield is the large component, while the other electronics are configured to be placed on the circuit board underneath the RF shield and are hence smaller.

However, providing an appropriate amount of accurately placed solder paste for both large and small components presents a challenge. For example, a thinner stencil is generally conducive for applying solder paste for smaller components, whereas a thicker stencil is generally conducive for applying solder paste for larger components. Previous solutions to this problem include using multiple stencils with multiple rounds of solder paste application, and using specialized "step" stencils having variable thickness. This can introduce cost and complexity into the manufacturing process, and can reduce quality yields in the finished product.

European Patent Publication No. EP 1,445,999 discloses a method of providing a printed wire board with a shield can. The method comprises the steps of: providing an electrically conductive shield can with a rim; providing a groove on a surface of the printed wire board; applying solder paste to the printed wire board to fill the groove; positioning the shield can on the solder paste; and heating and cooling the printed wire board to solder the shield can thereto. The solder paste may be deposited by screen printing or stencil printing.

United States Patent Application Publication No. US 2001/002877 discloses an apparatus and method for inhibiting EMI leakage, in which an enclosure for surrounding EMI producing circuit components has spaced-apart protrusions which extend into a host printed circuit board to make contact with an internal ground layer thereof.

United States Patent No. 6,462,436 discloses an EMI shield having an angled edge which fits within an angled mating groove of a substrate associated with a circuit board. The EMI shield may further be electrically connected to a ground of the circuit board.

### SUMMARY

An object of the present technology is to provide a grooved circuit board accommodating mixed-sized components, and associated methods. In accordance with an aspect of the present technology there is provided a method of preparing a circuit board, the circuit board comprising: a surface layer having a predetermined region configured to accommodate one or more first components; and an insulating layer adjacent to and in contact with the surface layer; wherein the method comprises forming an elongated groove in the surface layer adjacent to the predetermined region, the elongated groove extending a determined depth into the insulating layer and configured to accommodate a corresponding elongated footing of a second component, a body portion of the second component extending overtop of the first component, said elongated footing defining a portion of a perimeter of the second component, wherein evaluating the determined depth comprises: determining a maximum stencil thickness based on a minimum aperture size required in a stencil to be used for depositing conductive paste onto the surface layer for accommodating the one or more first components; determining a minimum conductive paste depth required for the second component; providing the stencil having a selected stencil thickness less than or equal to the maximum stencil thickness; comparing the minimum conductive paste depth for the second component with the selected stencil thickness, the minimum conductive paste depth exceeding the selected stencil thickness; and determining the determined depth to be at least equal to a difference between the minimum conductive paste depth and the selected stencil thickness.

In accordance with an aspect of the present technology, a circuit board is obtained by a method of preparing a circuit board as described below, the circuit board comprising: a surface layer having a predetermined region configured to accommodate one or more first components; and an insulating layer adjacent to and in contact with the surface layer; characterized in that the method comprises forming an elongated groove in the surface layer adjacent to the predetermined region, the elongated groove extending a determined depth into the insulating layer and configured to accommodate a corresponding elongated footing of a second component, a body portion of the second component extending overtop of the first component, said elongated footing defining a portion of a perimeter of the second component, wherein evaluating the determined depth comprises: determining a maximum stencil thickness based on a minimum aperture size required in a stencil to be used for depositing conductive paste onto the surface layer for accommodating the one or more first components; determining a minimum conductive paste depth required for the second component; providing the stencil having a selected stencil thickness less than or equal to the maximum stencil thickness; comparing the minimum conductive paste depth for the second component with the selected stencil thickness, the minimum conductive paste depth exceeding the selected stencil thickness; and determining the determined depth to be at least equal to a difference between the minimum conductive paste depth and the selected stencil thickness.

### BRIEF DESCRIPTION OF THE DRAWINGS

Further features and advantages of the present technology will become apparent from the following detailed description, taken in combination with the appended drawings, in which:
FIG. 1A illustrates a method of preparing a circuit board for assembly according to embodiments of the present technology.
FIG. 1B illustrates a method of preparing a circuit board for assembly according to embodiments of the present technology.
FIG. 2 illustrates a method of preparing a circuit board for assembly according to embodiments of the present technology.
FIG. 3 illustrates a method for fabricating a circuit board and associated stencil for depositing conductive paste thereon according to embodiments of the present technology.
FIG. 4A illustrates a stencil on a circuit board in accordance with embodiments of the present technology.
FIG. 4B illustrates a stencil on a circuit board in accordance with embodiments of the present technology.
FIGs. 5A to 5E illustrate, in cross-sectional view, the deposition of conductive paste onto a circuit board via a stencil in accordance with embodiments of the present technology.
FIG. 6A illustrates a top view of a circuit board in accordance with embodiments of the present technology.
FIG. 6B illustrates a stencil comprising a set or mesh of apertures in accordance with embodiments of the present technology.
FIG. 7 illustrates, in cross-sectional view, a circuit board accommodating a component via both an elongated groove and surface-layer pads.

It will be noted that throughout the appended drawings, like features are identified by like reference numerals.

### DETAILED DESCRIPTION

The present technology addresses a problem pertaining to manufacturing circuit assemblies comprising mixed-size components. The present disclosure provides a circuit board which more effectively accommodates mixed-size components, such as smaller fine-pitched surface-mount components mounted under a larger surface-mount RF shield, or smaller surface-mount components along with larger components exhibiting substantial coplanarity variation or for which a strong mechanical connection is desired, or smaller surface-mount components along with larger components which, without the benefit of the present technology, would extend above the circuit board surface to an undesirably large distance. Conventionally, solder paste is applied to a planar outer surface of a printed circuit board, and the surface is then populated with mixed-sized surface-mount components. However, with current solder paste printing techniques, it is difficult to adequately apply solder paste for both small and large components without resorting to more complex and hence more problematic approaches, such as multiple solder printing passes, solder overprinting, solder pre-form pallet, usage of step stencils or a combination thereof. A further related problem is that large components such as RF shields and other components may exhibit higher footing coplanarity variation than can be compensated for by the depth of solder paste typically applicable via relatively thin stencils, thus leading to solder open problems for said large components.

The present technology addresses the foregoing technical problems by providing a circuit board, method of preparing a circuit board, and method of manufacturing a circuit assembly comprising a circuit board, wherein the circuit board comprises a groove configured to receive conductive paste.

Accordingly, an aspect of the present technology provides a circuit board. The circuit board comprises a surface layer having a predetermined region configured to accommodate a first component and an insulating layer adjacent to the surface layer. An elongated groove is formed in the surface layer adjacent to the predetermined region, the elongated groove extending a predetermined distance into the insulating layer. Hence a bottom of the groove may comprise conductive material such as copper, adequately patterned and isolated from other copper traces, and optionally connected to a ground plane, for example. In some embodiments, the elongated groove may extend partway to or even beyond such an interior conductive layer. The elongated groove is configured to accommodate a corresponding elongated footing of a second component. In some embodiments, the elongated groove comprises conductive material such as copper plated onto the sidewalls, groove bottom, or both. The elongated footing may define a substantial portion of a perimeter of the second component. A body portion of the second component may extend overtop of the first component.

In embodiments of the present technology, the elongated groove generally extends to an interior conductive layer of a multilayer printed circuit board. By extending the groove to terminate at an interior conductive layer, a component accommodated by the groove can be electrically connected to that interior conductive layer. The interior conductive layer may in turn be connected to a power plane, ground plane, other electronic components or signal traces, or the like, or a combination thereof. Terminating the groove at an interior conductive layer also provides for a conductive bottom of the groove, which facilitates retention of conductive pastes such as solder paste.

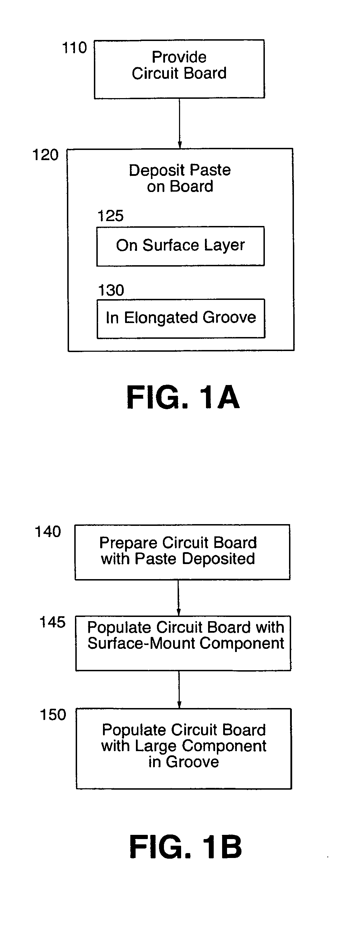

Another aspect of the present technology provides a method of preparing a circuit board for assembly. With reference to FIG. 1A, the method comprises: providing **110** the circuit board as described above; and depositing **120** conductive paste onto the circuit board, for example via a stencil in a paste printing process. In some embodiments, a single stencil with uniform thickness may be used in a one-pass printing process for both small and large components, thus simplifying the process. The conductive paste is deposited **125** on the predetermined region of the circuit board surface layer in a pattern corresponding to a footprint of the first component. The conductive paste is further deposited **130** in the elongated groove of the circuit board for reliably accommodating the elongated footing of the second component. In some embodiments, at least a portion of the elongated groove may be pre-filled with solder paste prior to printing. Pre-filling of paste may be facilitated via stencil, targeted paste injection, wave soldering, or the like.

Yet another aspect of the present technology provides a method of manufacturing a circuit assembly comprising the circuit board as described above. With reference to FIG. 1B, the method comprises: preparing the circuit board **140** as described above with respect to FIG. 1A; and populating the circuit board with at least the first component **145** followed by at least the second component **150**. Thus, the second component, such as an RF shield, may be placed overtop of a smaller first component.

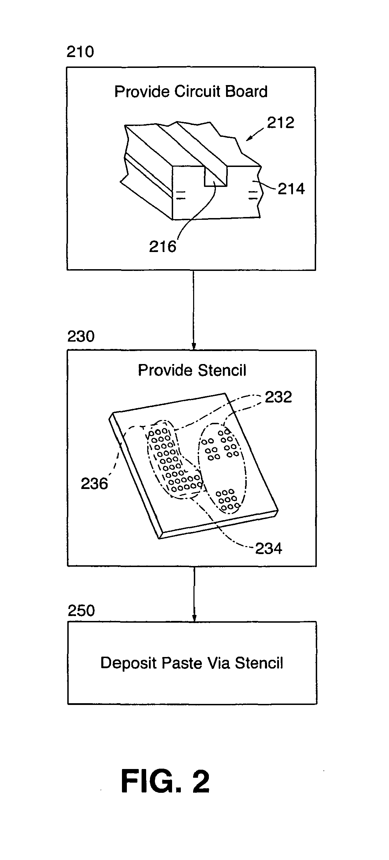

Yet another aspect of the present technology provides another, related method of preparing a circuit board for assembly. With reference to FIG. 2, the method comprises providing **210** a circuit board, providing **230** a stencil, and depositing **250** conductive paste onto the circuit board in a predetermined pattern via the stencil. In more detail, and as illustrated in cross-sectional view, the circuit board comprises: a surface layer **212;** an insulating layer **214** adjacent to the surface layer; and an elongated groove **216** formed in the surface layer and extending a predetermined distance into the insulating layer, for example the groove depth extending to and terminating at a predetermined interior conductive layer of a multilayer circuit board, such as the nearest interior conductive layer to the surface layer, or a deeper interior conductive layer. The elongated groove is configured to accommodate a corresponding elongated footing of a component. The stencil comprises a plurality of apertures **232** configured for conveying conductive paste to the circuit board in the predetermined pattern when the stencil is in registration with the circuit board. A subset **234** of the plurality of apertures is configured for conveying said conductive paste to the elongated groove. A perimeter of the subset is configured **236** to substantially sealingly engage with the circuit board during conveyance of the conductive paste to the elongated groove.

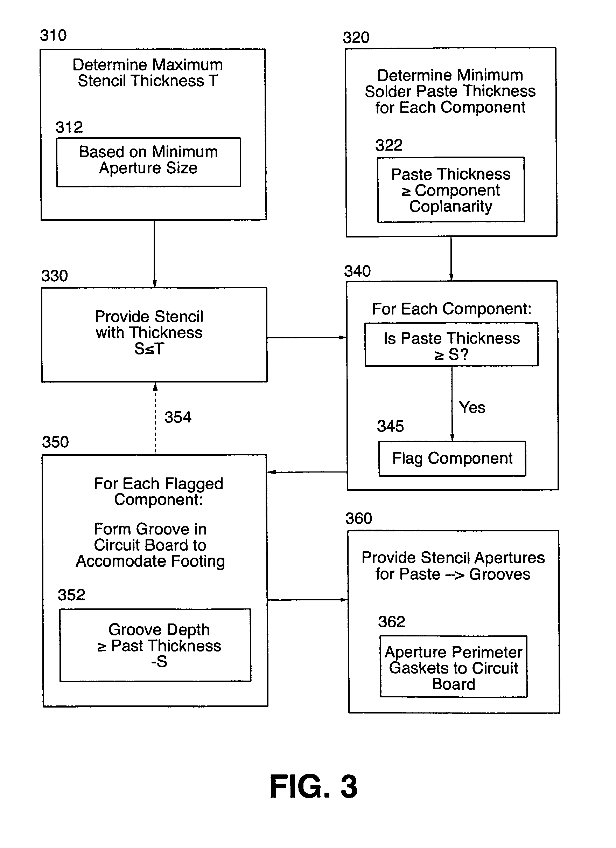

Yet another aspect of the present technology provides a method for fabricating a circuit board and associated stencil for depositing conductive paste thereon, a circuit board and stencil designed by that method, or both. With reference to FIG. 3, the method comprises determining **310** a maximum stencil thickness. In some embodiments, the maximum stencil thickness may be based **312** on a minimum aperture size required in the stencil for patterning conductive paste onto the circuit board. For example, the minimum aperture size may be determined by the finest-pitched footprint of components to be accommodated by the circuit board. As a further example, the thickness may be determined based on a predetermined minimum aspect ratio such as 1.1 or 1.5, or a predetermined minimum area ratio such as 0.6 or 0.66. The method further comprises determining **320** a minimum solder paste thickness for each component to be accommodated by the circuit board. For example, a requirement may be that solder paste thickness be at least equal **322** to a coplanarity measure of an associated component. The method further comprises providing **330** a stencil with a selected thickness less than or equal to the maximum stencil thickness, as determined in **310.** The provided stencil may be selected from a plurality of discrete, standardized stencil thicknesses. The method further comprises comparing **340** the minimum solder paste thickness for each component, as determined in **310,** to the selected stencil thickness and flagging **345** the components for which a minimum solder paste thickness exceeds the selected stencil thickness. The method further comprises forming **350,** for each flagged component, one or more grooves in the circuit board to accommodate a footing of the flagged component, the one or more grooves configured **352** to have a depth at least equal to a difference between the minimum solder paste thickness for the flagged component and the selected stencil thickness. The method may further comprise providing **360** a plurality of apertures in the stencil, configured for conveying conductive paste to the grooves, such that a perimeter of the plurality of apertures is configured **362** to substantially sealingly engage with the circuit board during conveyance of the conductive paste to the grooves.

In some embodiments, the groove depths and selected stencil thickness may be determined in combination, for example by way of the groove depths informing **354** selection of stencil thickness in a loop, or by concurrent selection. For example, the stencil thickness may be selected to be as thin as possible subject to the resulting grooves being shallower than a predetermined maximum. The maximum may be, for example, the depth to a predetermined interior conductive layer of the circuit board.

In embodiments of the present technology, the groove depth is constrained such that the groove terminates at an interior conductive layer of a multilayer circuit board. The groove may thus be configured to terminate at the first, second or further interior conductive layer encountered starting from the surface layer and proceeding into the multilayer circuit board. Thus the groove depth may be quantized to the interior conductive layer depths.

As used herein, the term "conductive paste" or simply "paste" may refer to solder paste, such as tin-lead or lead-free paste, or to solder paste alternatives, such as electrically conductive resins, pastes or adhesives. The type of conductive paste to be used may depend on several factors, such as printability.

As used herein, the terms "coplanarity variation," "coplanarity," and "coplanarity measure" refers to a measurement of vertical deviation of a component's footing or footprint, such as a surface-mount electronic component, from a seating plane. Coplanarity may be measured by placing the component on a flat surface and measuring the maximum perpendicular distance from the surface to the component footing. If the entire footing contacts the surface, the coplanarity measure is zero. Coplanarity is typically assessed via statistical sampling within batches of components.

In embodiments of the present technology, the elongated groove facilitates deposition of a greater depth and volume of conductive paste therein, via processes such as stencil-based solder paste printing. For example, the depth of paste deposited within the groove may be increased, beyond the depth of paste deposited on the surface layer, by about the depth of the groove. Similarly, the volume of paste deposited may be increased, beyond the volume of paste deposited on the surface layer, by about the volume of the groove. This increased amount of paste may derive one or more benefits as described herein.

In embodiments of the present technology, an increased depth of conductive paste, as facilitated by the groove, may aid in addressing problems, such as solder opens, resulting from coplanarity issues of large components accommodated in the groove. For example, for a component having a footing with a predetermined coplanarity measure of x mm, it may be desirable to have a paste depth of at least x mm deposited on a corresponding portion of the circuit board.

In bulk manufacturing, it is typical for coplanarity variation to differ within component batches. For example, 80% of components may have a coplanarity variation less than *x₁*, 90% of components may have a coplanarity variation less than *x₂*, 95% of components may have a coplanarity variation less than *x*₃, and so on. In embodiments of the present technology, a groove depth may be configured to accommodate component variation for a predetermined percentage of components. Generally, it is desirable to accommodate as large a percentage as feasible, subject to other considerations. For example, it may be desirable to limit the groove depth so as not to cross one or more internal conductive layers of the circuit board, so as not to compromise the structural integrity of the circuit board, or to otherwise limit expenses or yield losses.

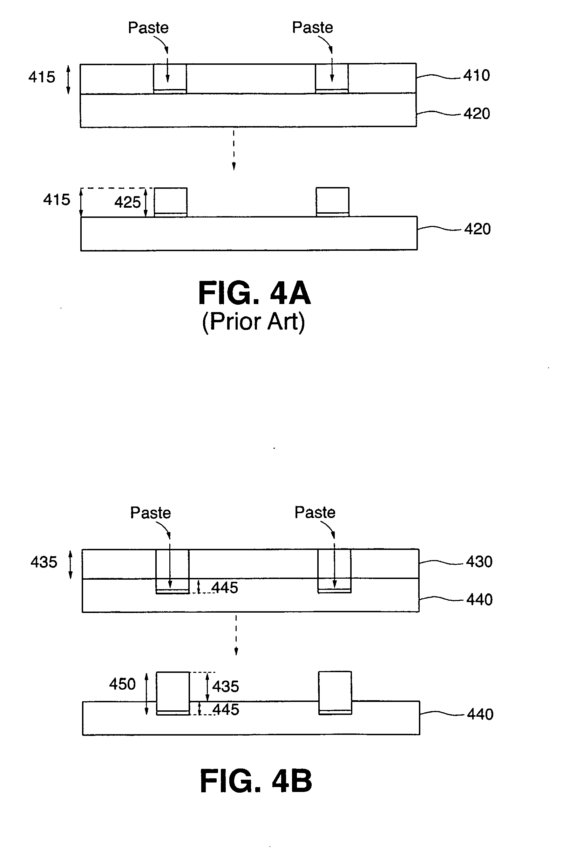

For paste deposited by a stencil substantially flush to the circuit board, achieving a paste depth of x mm traditionally required that the stencil also be at least x mm, since the stencil apertures are substantially filled with paste due to the printing process. (Additional paste depth might be achievable by lifting the stencil away from the circuit board by a small distance, however this may not be desirable for example due to lack of gasketing of the stencil and the circuit board.) FIG. 4A illustrates how a stencil **410** having thickness **415** and flush to a circuit board **420** results in a depth **425** of deposited paste substantially the same as the stencil thickness **415**.

In contrast and in accordance with the present disclosure, for paste deposited into a circuit board groove of depth y mm by a stencil substantially flush to the circuit board surface, achieving a paste depth of *x* mm requires that the stencil be at least (*x-y*) mm. This may allow the stencil thickness to be substantially reduced for a given coplanarity. Alternatively, this may allow for components with greater coplanarity to be used with a given stencil thickness. FIG. 4B illustrates how a stencil **430** having thickness **435** and flush to a circuit board **440** overtop of a groove having depth **445** can results in a depth **450** of deposited paste substantially equal to the stencil thickness **435** plus the groove depth **445.** As an example, x may be about 0.1 mm, corresponding to a typical coplanarity measure of an RF shield or other component, and y may be about 0.02 mm or greater, thereby enabling the stencil thickness to be reduced from about 0.1 mm to about 0.08 mm or less. Furthermore, *y* may be constrained so that the groove terminates at an interior conductive layer of a multilayer circuit board.

Roughly speaking, in embodiments of the present technology, the volume and depth of stencil apertures overtop of the groove is increased by the volume and depth, respectively of a corresponding portion of the groove below the aperture. The general situation may be more complex, since the same groove may underlie plural apertures. Regardless, this effective increase in aperture volume and depth allows a corresponding increase in deposited paste volume during printing. Moreover, the problem of paste sticking to the sidewall of the stencil aperture is reduced since the stencil is made thinner than would otherwise be required for depositing paste to an adequate depth for accommodating larger components. A thinner stencil leads to an increased area ratio for a given aperture, which may lead to a reduced tendency for paste to stick in the stencil apertures.

In embodiments of the present technology, and as mentioned above, the use of grooves may allow for a thinner stencil to be used, which may be advantageous when smaller components are also to be accommodated on the circuit board.

For example, fine-pitch components typically require paste to be printed through correspondingly small stencil apertures. The small apertures in turn typically require use of a thin stencil, since apertures which are tall and narrow are generally known to produce unreliable results, for example due to excess paste sticking in the apertures. For example, some general rules of thumb dictate that the stencil aspect ratio, defined as the ratio of aperture opening to stencil thickness, should be greater than about 1.1 to 1.5, depending on how the stencil is cut. As another example, the stencil area ratio, defined as the ratio of aperture area to area of the aperture walls, should be greater than about 0.6 or 0.66.

For example, based on a required stencil area ratio of at least 0.6, micro-BGA components having 0.3 mm pitch and hence requiring paste deposited through stencil apertures of about 0.2 mm by 0.2 mm would require a stencil thickness of about 0.08 mm or less. Hence the situation illustrated in FIG. 1B, with x=0.1 mm and y=0.02 mm or greater, may be sufficient for accommodating such micro-BGA components.

In embodiments of the present technology, the grooves may facilitate providing an alternative stencilling solution for certain mixed-component circuit boards. For example, consider a circuit board on which small components, requiring a stencil thickness of less than *z*₁ mm, and large components requiring a paste thickness of at least *z₂* mm, are to be populated. For *z*₂>*z*₁ and a planar circuit board, there is no uniform stencil thickness that accommodates both these requirements, and hence a more complex solution such as step stencilling, multi-pass printing, or the like must be implemented. Instead, by using a stencil of thickness *z*<*z₁* and providing grooves in the circuit board having a depth of at least *z₂*-*z* mm, a single, uniformly-thick stencil may be used.

Furthermore, in embodiments of the present technology, the grooves may aid in containment of paste therein, which may reduce potential problems due to paste being misprinted to inappropriate regions of the circuit board.

In embodiments of the present technology, conductive paste deposited within the groove may be at least partially displaced when an elongated footing of a component is subsequently placed into the groove. Furthermore, the volume occupied by certain types of conductive paste, such as solder paste, may be reduced via further processing steps, such as reflow, as would be readily understood by a worker skilled in the art. Embodiments of the present technology may be configured to compensate for paste displacement, paste volume reduction, or both. For example, groove depths, other groove dimensions, stencil thickness, or a combination thereof, may be determined based at least in part on anticipated paste displacements, paste volume reductions, or both.

The details and particulars of these aspects of the technology will now be described below, by way of example, with reference to the attached drawings.

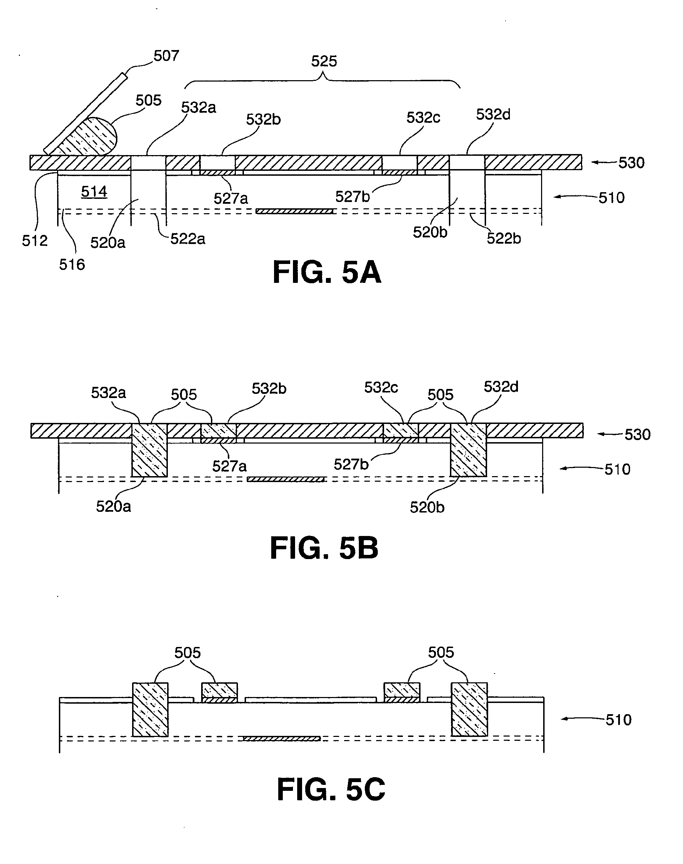

FIGS. 5A to 5E illustrate, in cross-sectional view, deposition of conductive paste **505** onto a circuit board **510** via a stencil **530,** in accordance with an embodiment of the present technology. It should be noted that FIGS. 5A to 5E are not to scale, the vertical dimension being exaggerated for clarity. Referring to FIG. 5A, the conductive paste **505** is drawn across the stencil **530** by a squeegee **507**, as would be readily understood by a worker skilled in the art. The paste **505** is pressed through various apertures in the stencil **530**, such as apertures **532a, 532b**, **532c**, **532d**. Apertures **532a** and **532d** are aligned overtop of groove portions **520a** and **520b** corresponding to one or more grooves formed in a surface layer **512** of the circuit board **510** and extending into an insulating layer **514**. As illustrated, the groove portions **520a** and **520b** extend to an internal conductive layer **516** of the circuit board **510**. However, the groove portions may alternatively extend partway to or even beyond the internal conductive layer **516**. As also illustrated, the internal conductive layer **516** is patterned so that the bottom of the groove portions **520a** and **520b** comprise conductive material **522a** and **522b**.

Referring still to FIG. 5A, the circuit board **510** comprises a region **525** which comprises pads or lands on the surface layer **512** for receiving one or more components. Cross sections of pads **527a** and **527b** are illustrated in FIG. 5A. Apertures **532b** and **532c** are aligned overtop of pads **527a** and **527b**, respectively.

Referring to FIG. 5B, the conductive paste **505** has been deposited by the squeegee **507** into the groove and onto appropriate portions of the surface layer. For example, the groove portions **520a** and **520b** and corresponding apertures **532a** and **532d** are substantially filled with paste **505**, as are the apertures **532b** and **532c.** Notably, the height of the paste **505** deposited through each aperture **532a, 532b**, 532c, **532d** reaches substantially to the upper surface of the stencil **530**. Thus, the depth of the deposited paste **505** is equal to the thickness of the stencil **530** plus the depth of the groove below the stencil, where appropriate.

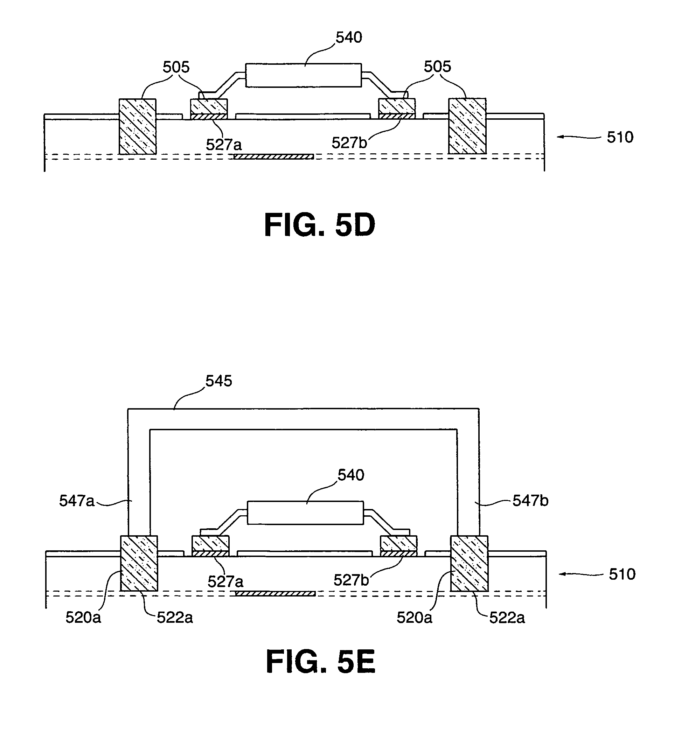

FIG. 5C illustrates the circuit board **510** with deposited paste **505**, after the stencil **530** has been removed. FIG. 5D illustrates the circuit board **510** with a first, small SMT component **540**, mounted at least in part above the pads **527a** and **527b** and held by the paste **505**. FIG. 5E illustrates the circuit board **510** with a second, large SMT component **545** such as an RF shield subsequently mounted overtop of the groove, into the groove, or both. For example, footing portions **547a** and **547b** of the component **545** may be inserted at least partway into groove portions **520a** and **520b**, respectively and may optionally contact the conductive material **522a** and **522b.**

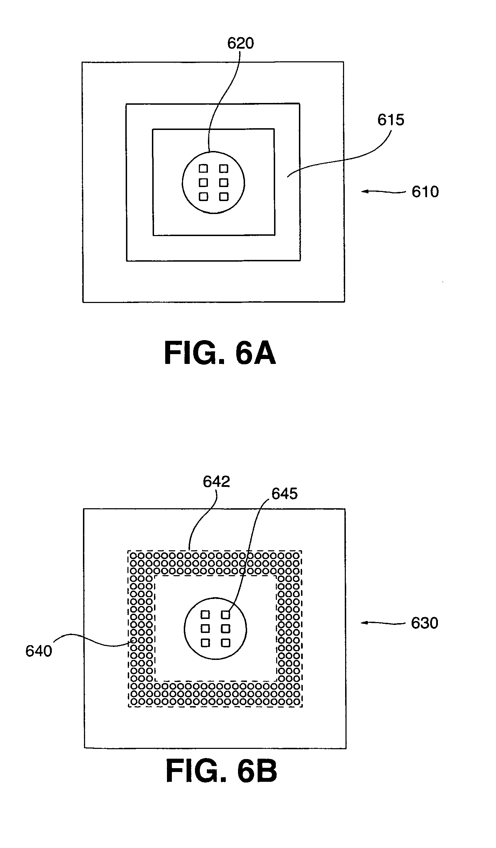

FIG. 6A illustrates a top view of a circuit board **610** provided in accordance with an embodiment of the present technology. The circuit board **610** comprises an elongated groove **615** for receiving paste, a large component, or both. The large component may be an RF shield, vibrator motor, mechanical connector, or other component. The circuit board **610** further comprises a pattern of lands **620** which receive paste via a stencil and subsequently receive SMT components placed underneath the large component. As illustrated, the groove **615** completely encircles a portion of the circuit board **610** comprising the lands **620.** Other component lands or pads may be formed outside of the encircled portion. Lands or pads for plural components may be formed on the encircled portion. In other embodiments, one or more breaks may be formed in the groove **615**, provided that the groove still accommodates an elongated footing of the large component, said elongated footing defining a substantial portion of a perimeter of the large component.

FIG. 6B illustrates a stencil **630** comprising a set or mesh of apertures **640**, configured to facilitate deposition of paste into the groove **615** of the circuit board **610,** in accordance with embodiments of the technology. The stencil **630** may comprise other apertures for depositing paste onto other pads and/or lands of the circuit board surface, such as apertures **645**. The stencil **630** is placed substantially flush to the circuit board **610** and registered therewith by aligning the stencil pattern with circuit board features such as pads **615** and groove **620**, for accurate deposition of conductive paste, as would be readily understood by a worker skilled in the art. The set or mesh of apertures **640** over the groove **620** is configured to convey conductive paste to the entirety of the groove. The set or mesh of apertures **640**, may define a perimeter **642** which substantially sealingly engages, or gaskets, with the groove **620**, thereby facilitating deposition of paste into the groove while inhibiting deposition of paste immediately adjacent to the groove. Alternatively, a single aperture may be used for deposition of paste in a sufficiently small groove, provided that such an aperture does not completely separate the stencil into separate pieces.

Embodiments of the technology relate to single-layer or multilayer printed circuit boards having a predetermined total thickness, for example 63 mils (1.57 mm) or 93 mils. Insulating layers, situated between the conductive layers, may have a thickness which depends in part on the total board thickness and the number of internal conductive layers of a multilayer board. In some embodiments, insulating layer thickness may be in the 50 µm to 100 µm range, 100 µm to 300 µm range, or greater. A groove cut from the surface layer entirely through the first insulating layer to the next conductive layer may thus provide additional depth of paste commensurate with the insulating layer thickness. This additional depth may be sufficient to compensate for relatively high coplanarity of large components.

In an exemplary embodiment, a groove, which surrounds substantially all of a predetermined region of the circuit board surface layer, is 70 µm to 80 µm deep and 0.5 mm to 1 mm wide. An associated stencil may be 70 µm to 100 µm thick, for example. Thus, use of a groove to accommodate a component with 100 µm coplanarity may allow stencil thickness to be decreased from 4 mils (about 100 µm) to a lower thickness, such as 3 mils (about 75 µm).

In some embodiments, the stencil comprises an aperture or set of apertures, for conveying conductive paste into the elongated groove, the aperture or set of apertures being wider than the elongated groove. Thus the stencil is configured to facilitate a predetermined degree of overprinting to the groove, which may facilitate deposition of an increased amount of paste, deposition of paste at an increased rate, or both.

In embodiments of the present technology, if the elongated groove penetrates a multilayer circuit board to or past one or more internal layers, traces patterned on those internal layers may have to be re-routed to accommodate the groove, as would be readily understood by a worker skilled in the art.

In embodiments of the present technology, the component accommodated in the groove is an RF shield, which may be fitted overtop of other smaller components to shield same. In embodiments of the present technology, the component accommodated in the groove is another large component such as a motor housing, connector, or other component. Such components may comprise a portion, such as an outer perimeter connector, which is to be attached to the circuit board to provide mechanical strength. This portion may further exhibit relatively high coplanarity variation. Thus, these portions of the components may benefit from being accommodated in a groove, which allows for a greater depth of conductive paste and hence increased mechanical strength, increased tolerance for coplanarity variation, or both.

In embodiments of the present technology, the outer perimeter connector of a component such as a motor housing, connector, or other component, may be connected to a ground plane via the bottom of the groove. Other connectors of the component, for example power connectors, signal connectors, or both, may be connected to predetermined portions of the circuit board by wires extending from inside or outside a perimeter of the groove, or by connectors that mate with lands on the surface layer of the circuit board. Thus, in some embodiments, the large component may be coupled to both the elongated groove and to pads or lands on the circuit board surface layer. Conductive paste may be applied to both the elongated groove and pads or lands via a stencil, as described herein.

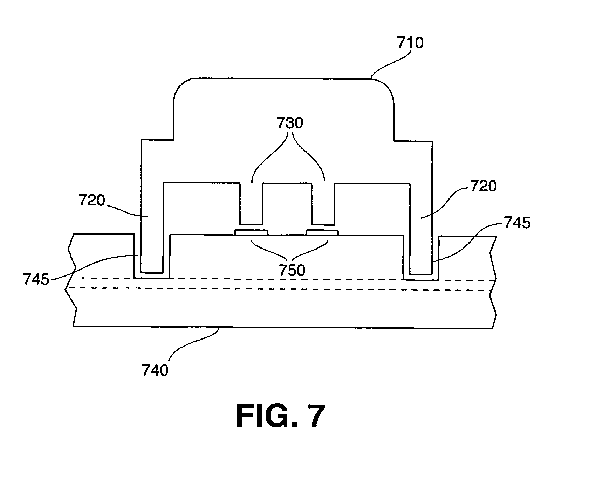

FIG. 7 illustrates, in cross section, a component **710** having an elongated footing **720** and one or more additional terminals **730**. For example, the elongated footing **720** may function as a ground connector, while the additional terminals **730** may function as power connectors, signal connectors, or the like, or a combination thereof. The circuit board **740** comprises an elongated groove **745** which is configured to accommodate the elongated footing **720**. The bottom of the elongated groove **745** is connected to a ground plane of the circuit board. The circuit board **740** further comprises pads **750** on the circuit board surface layer which are configured to mate with the additional terminals **730**. In one embodiment, one or more apertures (not shown) are provided in the component **710** for accessing the interface between the additional terminals **730** and the pads **750**. The apertures may provide air access for facilitating solder paste reflow in a reflow oven, mechanical access, or both.

In embodiments of the present technology, the groove may be used to accommodate components in order to reduce the overall height of the circuit assembly. For example, a component having a predetermined height h accommodated in a groove of depth y may result in the component rising above the surface layer to a distance of *h*-*y*, which is less than h. This may facilitate providing a circuit assembly with a lower overall profile provided the higher components are accommodated in a groove.

This technology has been described in terms of specific implementations and configurations (and variants thereof) which are intended to be exemplary only. The scope of the exclusive right sought by the applicant is therefore intended to be limited solely by the appended claims.

## Claims

1. A method of preparing a circuit board (510), the circuit board comprising:
a surface layer (512) having a predetermined region configured to accommodate one or more first components; and an Insulating layer (514) adjacent to and in contact with the surface layer; wherein the method comprises forming an elongated groove (520a, 520b) in the surface layer adjacent to the predetermined region, the elongated groove extending a determined depth into the Insulating layer and configured to accommodate (350, 352) a corresponding elongated footing (547a, 547b) of a second component (545), a body portion of the second component extending overtop of the first component, said elongated footing defining a portion of a perimeter (615) of the second component, **characterised in that** evaluating the determined depth comprises:
i) determining a maximum stencil thickness based on a minimum aperture size required in a stencil to be used for depositing conductive paste onto the surface layer for accommodating the one or more first components;
ii) determining a minimum conductive paste depth required for the second component;
iii) providing the stencil having a selected stencil thickness less than or equal to the maximum stencil thickness;
iv) comparing the minimum conductive paste depth for the second component with the selected stencil thickness, the minimum conductive paste depth exceeding the selected stencil thickness; and
v) determining the determined depth to be at least equal to a difference between the minimum conductive paste depth and the selected stencil thickness.

2. The method according to claim 1, wherein the elongated footing has a predetermined coplanarity variation, and wherein conductive paste (505) is applied in the groove to a paste depth at least equal to the determined depth, the method further comprising configuring (320, 340, 350) the determined depth to facilitate the paste depth being at least equal to the predetermined coplanarity variation.

3. The method according to claim 1, wherein the conductive paste is deposited via the stencil to both the elongated groove and to the predetermined region, the conductive paste deposited to the predetermined region in a pattern corresponding to footprints (645) of the one or more first components.

4. The method according to claim 1, wherein the stencil has uniform thickness.

5. The method according to claim 1, wherein the elongated groove extends to an internal conductive layer (516) of the circuit board.

6. The method according to claim 1, further comprising depositing conductive paste (120) onto the circuit board, the conductive paste deposited on the predetermined region (125) in a pattern corresponding to a footprint of the first component and the conductive paste deposited In the elongated groove (130).

7. The method according to claim 6, wherein the elongated footing has a predetermined coplanarity variation, conductive paste is applied to the groove to adepth equal to a depth of the groove (445) plus the uniform thickness of the stencil (435), and the depth of the groove is configured (320, 340, 350) to facilitate the depth of the conductive paste being at least equal to the predetermined coplanarity variation.

8. The method according to claim 6, wherein the conductive paste is deposited via a stencil, the stencil comprising one or more apertures (640) for deposition of the conductive paste into the elongated groove, the one or more apertures defining a perimeter (642) around the elongated groove, the stencil configured to sealingly engage (360, 362) with the circuit board during deposition of the conductive paste into the elongated groove.

9. The method according to claim 1, wherein the second component is a radiofrequency shield.

## Patentansprüche

1. Verfahren zum Vorbereiten einer Platine (510), wobei die Platine eine Oberflächenschicht (512) mit einer vorbestimmten Region, die dazu konfiguriert ist, eine oder mehrere erste Komponenten unterzubringen, und eine Isolierschicht (514) aufweist, die an die Oberflächenschicht angrenzt und mit dieser in Kontakt ist, wobei das Verfahren ein Ausbilden einer länglichen Rinne (520a, 520b) in der Oberflächenschicht an die vorbestimmte Region angrenzend aufweist, wobei sich die längliche Rinne um eine bestimmte Tiefe in die Isolierschicht erstreckt und dazu konfiguriert ist, ein entsprechendes längliches Footing (547a, 547b) bzw. eine entsprechende längliche Auflage einer zweiten Komponente (545) unterzubringen (350, 352), wobei sich ein Hauptteilabschnitt der zweiten Komponente über die erste Komponente erstreckt, wobei das längliche Footing bzw. die längliche Auflage einen Teil einer Eingrenzung (615) der zweiten Komponente festlegt,
**dadurch gekennzeichnet, dass** Evaluieren der bestimmten Tiefe Folgendes aufweist:
i) Bestimmen einer maximalen Schablonendicke auf Grundlage einer minimalen Öffnungsgröße, die in einer Schablone benötigt wird, die zum Ablagern einer Leitpaste auf die Oberflächenschicht zum Unterbringen der einen oder der mehreren ersten Komponenten zu verwenden ist,
ii) Bestimmen einer minimalen Leitpastendicke, die für die zweite Komponente benötigt wird,
iii) Bereitstellen der Schablone mit einer ausgewählten Schablonendicke, die weniger als oder gleich wie die maximale Schablonendicke ist,
iv) Vergleichen der minimalen Leitpastentiefe für die zweite Komponente mit der ausgewählten Schablonendicke, wobei die minimale Leitpastentiefe die ausgewählte Schablonendicke übersteigt, und
v) Bestimmen, dass die bestimmte Tiefe mindestens gleich wie ein Unterschied zwischen der minimalen Leitpastentiefe und der ausgewählten Schablonendicke ist.

2. Verfahren nach Anspruch 1, wobei das längliche Footing bzw. die längliche Auflage eine vorbestimmte Komplanaritätsvariation aufweist, und wobei die Leitpaste (505) in die Rinne in einer Pastentiefe aufgetragen wird, die mindestens gleich wie die bestimmte Tiefe ist, wobei das Verfahren ferner ein Konfigurieren (320, 340, 350) der bestimmten Tiefe aufweist, zu vereinfachen, dass die Pastentiefe mindestens gleich wie die vorbestimmte Komplanaritätsvariation ist.

3. Verfahren nach Anspruch 1, wobei die Leitpaste über die Schablone sowohl an die länglichen Rinne als auch an die vorbestimmten Region abgelagert wird, wobei die Leitpaste auf der vorbestimmten Region in einem Muster abgelagert wird, das Fußabdrücken (645) der einen oder der mehreren ersten Komponenten entspricht.

4. Verfahren nach Anspruch 1, wobei die Schablone eine gleichmäßige Dicke aufweist.

5. Verfahren nach Anspruch 1, wobei sich die längliche Rinne zu einer internen Leitschicht (516) der Platine erstreckt.

6. Verfahren nach Anspruch 1, ferner mit Ablagern einer Leitpaste (120) auf die Platine, wobei die Leitpaste auf der vorbestimmten Region (121) in einem Muster abgelagert wird, das einem Fußabdruck der ersten Komponente entspricht, und wobei die Leitpaste in der länglichen Rinne (130) abgelagert wird.

7. Verfahren nach Anspruch 6, wobei das längliche Footing bzw. die längliche Auflage eine vorbestimmte Komplanaritätsvariation aufweist, wobei die Leitpaste an die Rinne in einer Dicke aufgetragen wird, die gleich einer Dicke der Rinne (445) plus die gleichmäßige Dicke der Schablone (435) ist, und wobei die Dicke der Rinne dazu konfiguriert (320, 340, 350) ist, zu vereinfachen, dass die Dicke der Leitpaste mindestens gleich wie die vorbestimmte Komplanaritätsvariation ist.

8. Verfahren nach Anspruch 6, wobei die Leitpaste über eine Schablone abgelagert wird, wobei die Schablone eine oder mehrere Öffnungen (640) zum Ablagern der Leitpaste in die längliche Rinne aufweist, wobei die eine oder die mehreren Öffnungen eine Eingrenzung (642) um die längliche Rinne festlegt, wobei die Schablone dazu konfiguriert ist, während der Ablagerung der Leitpaste in die längliche Rinne versiegelnd mit der Platine einzugreifen (360, 362).

9. Verfahren nach Anspruch 1, wobei die zweite Komponente ein Hochfrequenz- bzw. ein Funkfrequenz-Schild ist.

## Revendications

1. Procédé de préparation d'une carte de circuit imprimé (510), la carte de circuit imprimé comprenant : une couche de surface (512) ayant une région prédéterminée configurée pour recevoir un ou plusieurs premier(s) composant(s) ; et une couche isolante (514) adjacente à la couche de surface et en contact avec celle-ci ; le procédé comprenant le fait de former une rainure allongée (520a, 520b) dans la couche de surface de manière adjacente à la région prédéterminée, la rainure allongée s'étendant sur une profondeur déterminée dans la couche isolante et configurée pour recevoir (350, 352) une base allongée correspondante (547a, 547b) d'un deuxième composant (545), une partie de corps du deuxième composant s'étendant au-dessus du premier composant, ladite base allongée définissant une partie d'un périmètre (615) du deuxième composant, **caractérisé en ce que** l'évaluation de la profondeur déterminée comprend le fait :
i) de déterminer une épaisseur de pochoir maximale sur la base d'une taille d'ouverture minimale nécessaire dans un pochoir à utiliser pour déposer une pâte conductrice sur la couche de surface destinée à recevoir le ou les plusieurs premier(s) composant(s) ;
ii) de déterminer une profondeur de pâte conductrice minimale nécessaire pour le deuxième composant ;
iii) de fournir le pochoir ayant une épaisseur de pochoir sélectionnée inférieure ou égale à l'épaisseur de pochoir maximale ;
iv) de comparer la profondeur de pâte conductrice minimale pour le deuxième composant à l'épaisseur de pochoir sélectionnée, la profondeur de pâte conductrice minimale dépassant l'épaisseur de pochoir sélectionnée ; et
v) de déterminer la profondeur déterminée pour être au moins égale à une différence entre la profondeur de pâte conductrice minimale et l'épaisseur de pochoir sélectionnée.

2. Procédé selon la revendication 1, dans lequel la base allongée présente une variation de coplanarité prédéterminée, et dans lequel la pâte conductrice (505) est appliquée dans la rainure à une profondeur de pâte au moins égale à la profondeur déterminée, le procédé comprenant en outre le fait de configurer (320, 340, 350) la profondeur déterminée pour faciliter que la profondeur de pâte soit au moins égale à la variation de coplanarité prédéterminée.

3. Procédé selon la revendication 1, dans lequel la pâte conductrice est déposée par l'intermédiaire du pochoir à la fois sur la rainure allongée et sur la région prédéterminée, la pâte conductrice étant déposée sur la région prédéterminée selon un motif correspondant à des empreintes (645) du ou des plusieurs premier(s) composant(s).

4. Procédé selon la revendication 1, dans lequel le pochoir a une épaisseur uniforme.

5. Procédé selon la revendication 1, dans lequel la rainure allongée s'étend vers une couche conductrice interne (516) de la carte de circuit imprimé.

6. Procédé selon la revendication 1, comprenant en outre le fait de déposer une pâte conductrice (120) sur la carte de circuit imprimé, la pâte conductrice étant déposée sur la région prédéterminée (125) selon un motif correspondant à une empreinte du premier composant et la pâte conductrice étant déposée dans la rainure allongée (130).

7. Procédé selon la revendication 6, dans lequel la base allongée a une variation de coplanarité prédéterminée, une pâte conductrice est appliquée sur la rainure à une profondeur égale à une profondeur de la rainure (445) plus l'épaisseur uniforme du pochoir (435), et la profondeur de la rainure est configurée (320, 340, 350) pour faciliter que la profondeur de la pâte conductrice soit au moins égale à la variation de coplanarité prédéterminée.

8. Procédé selon la revendication 6, dans lequel la pâte conductrice est déposée par l'intermédiaire d'un pochoir, le pochoir comprenant une ou plusieurs ouverture(s) (640) pour le dépôt de la pâte conductrice dans la rainure allongée, la ou les plusieurs ouverture(s) définissant un périmètre (642) autour de la rainure allongée, le pochoir étant configuré pour venir en prise de manière étanche (360, 362) avec la carte de circuit imprimé pendant le dépôt de la pâte conductrice dans la rainure allongée.

9. Procédé selon la revendication 1, dans lequel le deuxième composant est un blindage radiofréquence.
